# EUROPÄISCHE PATENTSCHRIFT

(11) **EP 3 298 459 B1**
(45) Veröffentlichungstag und Bekanntmachung des Hinweises auf die Patenterteilung: **09.08.2023**
(21) Anmeldenummer: 16722864.2
(22) Anmeldetag: 10.05.2016
(51) Int. Cl.: G03F 7/20, G01B 11/14, G01D 5/26, G01D 5/347, G01B 11/02

(54) **POSITIONSSENSORVORRICHTUNG UND VERFAHREN ZUM ERMITTELN EINER POSITION ZUMINDEST EINES SPIEGELS EINER LITHOGRAPHIEANLAGE**
POSITION SENSOR DEVICE AND METHOD FOR DETERMINING A POSITION OF AT LEAST ONE MIRROR OF A LITHOGRAPHY SYSTEM
DISPOSITIF DE DÉTECTION DE POSITION ET PROCÉDÉ DE DÉTERMINATION D'UNE POSITION D'AU MOINS UN MIROIR D'UN SYSTÈME DE LITHOGRAPHIE

(30) Priorität: 20.05.2015 DE 102015209259
(43) Veröffentlichungstag der Anmeldung: 28.03.2018
(73) Patentinhaber: Carl Zeiss SMT GmbH, 73447 Oberkochen (DE)
(72) Erfinder: HORN, Jan, 80639 München (DE)
(74) Vertreter: Horn Kleimann Waitzhofer Patentanwälte PartG mbB
(86) Internationale Anmeldenummer: PCT/EP2016/060380
(87) Internationale Veröffentlichungsnummer: WO 2016/184715

(56) Entgegenhaltungen:
- DE-A1-102008 004 762
- DE-A1-102009 009 372
- DE-A1-102012 204 704
- DE-A1-102013 214 008
- GONZO L ET AL: "A Fast CMOS Optical Position Sensor With High Subpixel Resolution", IEEE TRANSACTIONS ON INSTRUMENTATION AND MEASUREMENT, IEEE SERVICE CENTER, PISCATAWAY, NJ, US, Bd. 53, Nr. 1, 1. Februar 2004 (2004-02-01), Seiten 116-123, XP011105486, ISSN: 0018-9456, DOI: 10.1109/TIM.2003.822013

## Beschreibung

Die vorliegende Erfindung betrifft eine Positionssensorvorrichtung und ein Verfahren zum Ermitteln einer Position zumindest eines Spiegels einer Lithographieanlage. Ferner betrifft die Erfindung ein Projektionssystem einer Lithographieanlage sowie eine Lithographieanlage.

Die Mikrolithographie wird zur Herstellung mikrostrukturierter Bauelemente, wie beispielsweise integrierter Schaltkreise angewendet. Der Mikrolithographieprozess wird mit einer Lithographieanlage durchgeführt, welche ein Beleuchtungssystem und ein Projektionssystem aufweist. Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat (z. B. ein Siliziumwafer) projiziert, um die Maskenstruktur auf die lichtempfindliche Beschichtung des Substrats zu übertragen.

Getrieben durch das Streben nach immer kleineren Strukturen bei der Herstellung integrierter Schaltungen werden derzeit EUV-Lithographieanlagen entwickelt, welche Licht mit einer Wellenlänge im Bereich von 0,1 nm bis 30 nm, insbesondere 13,5 nm verwenden. Bei solchen EUV-Lithographieanlagen müssen wegen der hohen Absorption der meisten Materialien von Licht dieser Wellenlänge reflektierende Optiken, das heißt Spiegel, anstelle von - wie bisher - brechenden Optiken, das heißt Linsen, eingesetzt werden. Aus gleichem Grund ist die Strahlformung und -projektion in einem Vakuum durchzuführen.

Die Spiegel können z. B. an einem Tragrahmen (Engl.: force frame) befestigt und wenigstens teilweise manipulierbar oder verkippbar ausgestaltet sein, um eine Bewegung eines jeweiligen Spiegels in bis zu sechs Freiheitsgraden und damit eine hochgenaue Positionierung der Spiegel zueinander, insbesondere im pm-Bereich, zu ermöglichen. Somit können etwa im Betrieb der Lithographieanlage auftretende Änderungen der optischen Eigenschaften, z. B. infolge von thermischen Einflüssen, ausgeregelt werden.

Für das Verfahren der Spiegel, insbesondere in den sechs Freiheitsgraden, sind diesen Aktuatoren zugeordnet, welche über einen Regelkreis angesteuert werden. Als Teil des Regelkreises ist eine Vorrichtung zur Überwachung des Kippwinkels eines jeweiligen Spiegels vorgesehen.

Das Dokument WO 03/052511 A2 zeigt eine Abbildungseinrichtung in einer Projektionsbelichtungsanlage für die Mikrolithographie. Die Abbildungseinrichtung hat wenigstens ein optisches Element und wenigstens einen einen Linearantrieb aufweisenden Manipulator zur Manipulation der Position des optischen Elements. Dabei weist der Linearantrieb einen angetriebenen Teilbereich und einen nicht angetriebenen Teilbereich auf, welche relativ zueinander in Richtung einer Bewegungsachse beweglich sind, wobei die Teilbereiche über Funktionselemente mit einer Wirkungsrichtung wenigstens annähernd senkrecht zur Bewegungsachse und über Funktionselemente mit einer Wirkungsrichtung wenigstens annähernd parallel zur Bewegungsachse zumindest zeitweise miteinander verbunden sind.

Ferner ist bekannt, ein an einem Spiegel angebrachtes Referenzmuster mittels eines optischen Gebers (Engl.: optical encoder) zu erfassen. Ein solcher optischer Geber liefert um 90° zueinander phasenverschobene Niederspannungssignale, auch A-Signal und B-Signal genannt, aber diese phasenverschobenen Spannungssignale sind allerdings rauschanfällig. Auch liefert der optische Geber eine mehrdeutige relative Position (Feinposition) gegenüber einer Einschalt-Position oder Referenz-Position, nicht aber eine eindeutige absolute Position (Grobposition). Somit ist ein weiterer Positionssensor für die Einschalt-Position erforderlich.

Die DE 10 2008 004 762 A1 beschreibt eine Messeinrichtung zum Überwachen einer lateralen Abbildungsstabilität einer Projektionsoptik während eines Belichtungsvorgangs. Die DE 10 2013 214 008 A1 offenbart eine Optikanordnung für ein Lithographiesystem, die eine Erfassungseinrichtung zum Erfassen von Strahlungssignalen von optischen Elementen aufweist, sowie eine Steuereinrichtung, in Abhängigkeit der Strahlungssignale eine Information über eine Eigenschaft einer optisch aktiven Fläche der optischen Elemente zu ermitteln. Die DE 10 2009 009 372 A1 beschreibt eine Vorrichtung zur Überwachung der Orientierung mindestens eines Spiegels eines Spiegelfelds, das beispielsweise in einer Projektionsbelichtungsanlage für die Mikrolithographie einsetzbar ist. Die DE 10 2012 204 704 A1 offenbart eine Messvorrichtung zum Vermessen einer Abbildungsgüte eines EUV-Objektivs.

Der Artikel "A Fast CMOS Optical Position Sensor With High Subpixel Resolution" (Nicola Massari et.al, IEEE Transactions on Instrumentation and Measurement, vol.53, No. 1, Februar 2004) beschreibt eine neuartige Struktur für einen optischen Positionssensor, der in CMOS-Technologie integriert ist und 20x20 Pixel aufweist.

Vor diesem Hintergrund besteht eine Aufgabe der vorliegenden Erfindung darin, das Ermitteln einer Position zumindest eines Spiegels einer Lithographieanlage zu verbessern.

Demgemäß wird eine Positionssensorvorrichtung zum Ermitteln einer Position zumindest eines Spiegels einer Lithographieanlage vorgeschlagen. Die Positionssensorvorrichtung weist eine mit dem Spiegel gekoppelte Musterbereitstellungseinrichtung zur Bereitstellung eines Musters auf, welches einen Informationsgehalt bei Ortsfrequenzen von zumindest 1/(500 µm) aufweist, eine Bilderfassungseinrichtung zur Erfassung des bereitgestellten Musters, wobei die Bilderfassungseinrichtung eine Optik und einen Bildsensor aufweist, wobei die Optik dazu eingerichtet ist, das bereitgestellte Muster mit den Ortsfrequenzen von zumindest 1/(500 µm) mit einer Intensitätsabschwächung von höchstens 99 % auf den Bildsensor abzubilden, und eine Bildauswerteeinrichtung zur Ermittlung der Position des Spiegels in Abhängigkeit von dem erfassten Muster.

Die vorliegende Positionssensorvorrichtung erfasst ein Bild des bereitgestellten Musters und kann damit auch als bildbasierte Positionssensorvorrichtung oder bildbasierter Positionssensor bezeichnet werden.

Durch die Verwendung des Musters mit einem Informationsgehalt bei Ortsfrequenzen von zumindest 1/(500 µm) kann die vorliegende Positionssensorvorrichtung eine hohe Messgenauigkeit bereitstellen. Dabei definieren die Ortsfrequenzen von zumindest 1/(500 µm) eine Mindestgenauigkeit der Positionsbestimmung, welche durch die vorliegende Positionssensorvorrichtung sichergestellt wird. Auch wenn das Muster Ortsfrequenzen von nur bis 1/(500 µm) enthält, sind Messgenauigkeiten von weit genauer als 1 µm möglich.

Durch die bildbasierte Positionssensorvorrichtung können parasitäre Effekte, wie etwa eine Skalierung oder ein Verkippen der Musterbereitstellungseinrichtung relativ zu der Bilderfassungseinrichtung, miterfasst und auch kompensiert werden. Die Bilderfassungseinrichtung stellt insbesondere ein digitales Bild des bereitgestellten Musters bereit. Das digitale Bild ist insbesondere als ein elektrisches Signal oder als eine elektrische Signalfolge ausgebildet, welche eine Information über die Position des Spiegels enthält oder diese repräsentiert.

Die Bilderfassungseinrichtung kann weiterhin dazu eingerichtet sein, eine Signalvorverarbeitung des erfassten digitalen Bildes zu digitalen Positionsdaten durchzuführen. Hierdurch wird ein Datenaufkommen bei einer Kommunikation mit einer externen Steuervorrichtung, welche insbesondere auch die Bildauswerteeinrichtung umfassen kann, deutlich reduziert.

Des Weiteren ist es auch möglich, dass sich mehrere Positionssensorvorrichtungen eine gemeinsame Datenleitung zum Übertragen ihrer jeweiligen Positionsdaten an die Steuervorrichtung teilen. Die Positionsdaten sind beispielsweise digitale Positionsdaten. Dabei kann beispielsweise ein Datenbus eingesetzt werden.

Insbesondere werden die Messsignale, welche das erfasste Muster repräsentieren, bereits an der Messstelle durch die Bilderfassungseinrichtung digitalisiert. Ein Erzeugen und Übertragen rauschanfälliger Spannungssignale ist demnach nicht mehr erforderlich.

Unter einem Muster ist insbesondere eine bearbeitete Oberfläche zu verstehen, wobei die bearbeitete Oberfläche einen Informationsgehalt der Ortsfrequenzen von zumindest 1/ (500µm) hat. Beispielsweise ist die bearbeitete Oberfläche eine metallbearbeitete Oberfläche oder eine bedruckte Oberfläche. Die metallbearbeitete Oberfläche kann beispielsweise durch Fräsen oder Schleifen hergestellt sein. Das Material des Musters kann beispielsweise Metall, Silicium oder Glas sein. Beispielsweise kann das Muster auch als metallbearbeitete Oberfläche einer Tragstruktur des Spiegels ausgebildet sein. Die Strukturierung der Oberfläche der Tragstruktur und damit der Informationsgehalt des Musters wird beispielsweise durch Fräsen oder Schleifen der Tragstruktur gebildet. Das Muster kann auch beispielsweise ein lithografisch hergestelltes Muster sein.

Insbesondere ist die Bildauswerteeinrichtung eine digitale Schaltung oder in einer digitalen Baugruppe integriert.

Durch die Integration in derselben integrierten Baugruppe kann Platz eingespart werden. Dadurch, dass die Lichtquelle, die Signalverarbeitungseinheit und vorzugsweise zusätzlich die Photodetektoren der Detektionseinheit in derselben integrierten Baugruppe vorgesehen sind, kann die Position wenigstens eines Spiegels sehr schnell ermittelt werden. Insbesondere die räumliche Zusammenfassung in der integrierten Baugruppe erlaubt eine sehr schnelle Signalverarbeitung. Die verkürzten Signalwege in der integrierten Baugruppe bedingen weiterhin den Vorteil einer Reduzierung der Störanfälligkeit.

Unter einer integrierten Baugruppe ist eine Anordnung mit einer Anzahl von integrierten Schaltungen und/oder Bauteilen zu verstehen, die auf einer Trägerleiterplatte oder mehreren Trägerleiterplatten angeordnet sind. Die integrierte Baugruppe kann auch als integrierte Sensorelektronik bezeichnet werden.

Beispielsweise die Signalverarbeitungseinheit kann als integrierte Schaltung ausgebildet sein. Ein Beispiel für ein auf der Trägerleiterplatte angeordnetes Bauteil ist die Lichtquelle. Die Trägerleiterplatte umfasst beispielsweise eine Keramikplatine.

Unter einer "integrierten Schaltung" ist vorliegend eine auf einem einzigen Halbleitersubstrat (Wafer) angeordnete elektronische Schaltung (auch als monolithischer Schaltkreis bezeichnet) zu verstehen.

Die digitale Schaltung ist beispielsweise eine programmierbare digitale Schaltung (field-programmable gate array, FPGA) oder eine anwendungsspezifische digitale Schaltung (application-specific integrated circuit, ASIC).

Die Bilderfassungseinrichtung umfasst zumindest ein photoempfindliches Element, welches ein optisches Signal (Licht, welches Teil des Musters ist) in ein elektrisches Signal wandelt. Das wenigstens eine photoempfindliche Element ist vorzugsweise Bestandteil der integrierten Baugruppe. Beispielsweise kann eine Kamera vorgesehen sein, welche eine Vielzahl der integrierten Baugruppen aufweist, wobei eine jeweilige integrierte Baugruppe dazu eingerichtet ist, jeweils einen Spiegel zu überwachen.

Die Bilderfassungseinrichtung weist eine Optik und einen Bildsensor auf, wobei die Optik dazu eingerichtet ist, das bereitgestellte Muster mit den Ortsfrequenzen von zumindest 1/(500 µm) mit einer Intensitätsabschwächung von höchstens 99 % auf den Bildsensor abzubilden.

Vorteilhafterweise definieren die Ortsfrequenzen von zumindest 1/(500 µm) eine Mindestgenauigkeit der Positionsbestimmung. Die Intensitätsabschwächung von höchstens 99 % stellt einen Mindestkontrast sicher. Der Bildsensor ist beispielsweise als Kamera ausgebildet. Die Kamera kann beispielsweise eine Ein-Objektiv-Kamera sein. Die Kamera kann auch als Multi-Apertur-Kamera, als eine Kamera mit einem Linsenarray, welche insbesondere für eine Mikrointegration vorteilhaft ist, oder auch als plenoptische Kamera ausgebildet sein.

Gemäß einer weiteren Ausführungsform sind der Bildsensor und die Bildauswerteeinrichtung in derselben integrierten Baugruppe vorgesehen.

Gemäß einer weiteren Ausführungsform ist die Musterbereitstellungseinrichtung dazu eingerichtet, das Muster mit einem ersten Musteranteil für eine Grobbestimmung der Position des Spiegels und mit einem zweiten Musteranteil für eine Feinbestimmung der Position des Spiegels bereitzustellen. Dabei weist der zweite Musteranteil einen Informationsgehalt bei Ortsfrequenzen von zumindest 1/(500 µm) auf.

Gemäß einer weiteren Ausführungsform sind der Bildsensor, die Bildauswerteeinrichtung und eine Lichtquelle zur Belichtung der Musterbereitstellungseinrichtung in einer integrierten Baugruppe, insbesondere in derselben integrierten Baugruppe, vorgesehen. Damit ist das Muster vorteilhafterweise durch eine lokal an der Messstelle vorgesehene Lichtquelle belichtbar. Ein die Genauigkeit der Positionserfassung potentiell beeinträchtigender Lichttransport über Lichtwellenleiter kann damit entfallen. Aufgrund der Einsparung der Lichtwellenleiter ergibt sich auch eine Kostenersparnis.

Die Lichtquelle ist weiterhin vorzugsweise dazu eingerichtet, einen modulierten Lichtstrahl zur Belichtung der Messeinheit bereitzustellen. Insbesondere ist der modulierte Lichtstrahl sinusförmig oder gepulst. Die Treiberschaltung für die Lichtquelle kann innerhalb des Vakuum-Gehäuses oder außerhalb des Vakuum-gehäuses vorgesehen sein.

Gemäß einer weiteren Ausführungsform ist die Musterbereitstellungseinrichtung dazu eingerichtet, das Muster mit einem periodischen Muster bereitzustellen, welches einen Informationsgehalt bei Ortsfrequenzen von zumindest 1/(500 µm) aufweist.

Das periodische Muster ist beispielsweise ein Sinusmuster, ein Rechteckmuster oder ein Chirpsignalmuster. Das periodische Muster ist insbesondere für eine Feinbestimmung der Position des Spiegels vorteilhaft.

Gemäß einer weiteren Ausführungsform ist die Musterbereitstellungseinrichtung dazu eingerichtet, das Muster mit einer Linie mit einer vorbestimmten Steigung für eine Grobbestimmung der Position des Spiegels und mit einem periodischen Muster für eine Feinbestimmung der Position des Spiegels, welches einen Informationsgehalt bei Ortsfrequenzen von zumindest 1/(500 µm) aufweist, bereitzustellen.

Das Muster mit der Linie mit der vorbestimmten Steigung ist vorteilhafterweise für eine Grobbestimmung der absoluten Position des Spiegels geeignet. Damit ist kein separater Sensor für die Grobbestimmung der Einschalt-Position des Spiegels mehr erforderlich. Die vorbestimmte Steigung der Linie ist insbesondere streng monoton, beispielsweise linear steigend oder linear fallend.

Gemäß einer weiteren Ausführungsform ist die Musterbereitstellungseinrichtung dazu eingerichtet, das Muster mit einem ersten Musteranteil, in welchem das periodische Muster angeordnet ist, und mit einem von dem ersten Musteranteil getrennten, zweiten Musteranteil, in welchem die Linie mit der vorbestimmten Steigung angeordnet ist, bereitzustellen.

Sowohl eine Feinbestimmung als auch Grobbestimmung der Position des Spiegels kann damit vorteilhafterweise mit nur einem Muster erreicht werden.

Gemäß einer weiteren Ausführungsform ist die Musterbereitstellungseinrichtung dazu eingerichtet, das Muster derart bereitzustellen, dass die Linie mit der vorbestimmten Steigung dem periodischen Muster überlagert ist.

Auch hierbei kann vorteilhafterweise sowohl eine Feinbestimmung als auch eine Grobbestimmung der Position des Spiegels mit nur einem Muster erzielt werden. Des Weiteren ergibt sich bei diesem Muster ein verbessertes Signal-RauschVerhältnis bei der Feinbestimmung der Position des Spiegels, da für das periodische Muster mehr Fläche zur Verfügung steht.

Gemäß einer weiteren Ausführungsform ist das periodische Muster ein Sinusmuster, ein Rechteckmuster oder ein Chirpsignalmuster.

Das Sinusmuster ist aufgrund geringer Komplexität leicht auszuwerten. Die Rechteckmuster sind einfach und kostengünstig herzustellen. Gegenüber Sinusmustern ist ggf. ein geringer Mehraufwand für das Auswerten erforderlich, insbesondere für ein Ausfiltern auftretender Oberschwingungen.

Chirpmuster erlauben eine äußerst genaue Bestimmung einer Positionsverschiebung gegenüber einem Referenzmuster, bei allerdings gesteigerter Komplexität der Auswertung, welche insbesondere mittels Korrelation erfolgt. Chirpmuster sind daher insbesondere dann geeignet, wenn eine Verschiebung des Musters sehr genau nur in Richtung der zu ermittelnden Position des Spiegels erfolgt.

Gemäß einer weiteren Ausführungsform ist die Bildauswerteeinrichtung dazu eingerichtet, die Position des Spiegels mittels einer Fouriertransformation, insbesondere mittels einer diskreten Fouriertransformation, des erfassten Musters zu bestimmen.

Die Feinbestimmung der Position des Spiegels ist mittels diskreter Fouriertransformation insbesondere bei periodischen Mustern aufgrund geringer Komplexität mit geringem Aufwand durchzuführen. Außerdem ist die Feinbestimmung der Position des Spiegels bei bekannter Ortsfrequenz des Musters bereits mittels eines Vorprodukts der Fouriertransformierten, dem komplexen Fourierkoeffizienten, möglich. Auch eine Verdrehung von Bilderfassungseinrichtung und Musterbereitstellungseinrichtung zueinander ist mittels diskreter Fouriertransformation, welche insbesondere eine zweidimensionale diskrete Fouriertransformation (2D-DFT) ist, vorteilhafterweise erfassbar. Eine Rotation des Musters führt zu einer entsprechenden Rotation in der Fouriertransformierten. Eine diskrete Fouriertransformation (DFT) ist eine Fouriertransformation, welche ein ortsdiskretes, periodisch fortgesetztes endliches Signal auf ein diskretes komplexes Frequenzspektrum abbildet, welches ein Amplitudenbild und ein Phasenbild aufweist. Bei einer zweidimensionalen diskreten Fouriertransformation (2D-DFT) erfolgt die Frequenztransformation sowohl in Richtung der zu bestimmenden Position des Spiegels als auch senkrecht dazu. Das erfasste Muster weist in Richtung der zu bestimmenden Position des Spiegels sowie senkrecht dazu Ortsfrequenzen auf. Diese zeigen sich im Amplitudenbild als Maximalwerte an Frequenzpunkten, welche diesen Ortsfrequenzen entsprechen. Dem Phasenbild ist an diesen Frequenzpunkten eine Feinposition des Spiegels entnehmbar.

Auch leichte Fokusänderungen stören die Bilderfassungseinrichtung nicht, solange die Maximalwerte im Amplitudenbild deutlich lokalisierbar sind. Bei größeren Fokusänderungen ist die Lokalisierung der Ortsfrequenzen im Amplitudenbild über Maximalwerte rauschbehafteter, und dies ist folglich auch für das Auslesen des Phasenbildes an diesen Ortsfrequenzen zutreffend. Eine Defokussierung ist aber auch für ein gezieltes Anti-Aliasing bei der Abbildung einsetzbar.

Gemäß einer weiteren Ausführungsform ist die Bildauswerteeinrichtung dazu eingerichtet, eine Ortsfrequenz des erfassten Musters aus einem Maximalwert einer Amplitude der Fouriertransformierten abzuleiten und eine Verschiebung des Musters zu einer Referenzposition aus einer Phase der Fouriertransformierten bei der abgeleiteten Ortsfrequenz abzuleiten.

Mittels Fouriertransformation ist die Verschiebung des erfassten Musters vorteilhafterweise bestimmbar, weil die Amplitude der Fouriertransformierten an der zu ermittelnden Ortsfrequenz des erfassten Musters maximal ist, und die Phase der Fouriertransformierten an dieser Ortsfrequenz der Verschiebung des erfassten Musters entspricht. Mittels der Fouriertransformation ist auch ein Abstand oder eine Abstandsänderung zwischen Bilderfassungseinrichtung und Musterbereitstellungseinrichtung vorteilhafterweise erfassbar und kompensierbar, weil eine Änderung der Ortsfrequenz einer Skalierung (Maßstabsänderung) des erfassten Musters und damit einer Abstandsänderung zwischen Bilderfassungseinrichtung und Musterbereitstellungseinrichtung entspricht. Eine Skalierung des Musters äußert sich demzufolge in einer dazu entgegengesetzten Skalierung in der Fouriertransformierten. Zu große Störungen beim Bestimmen der Position des Spiegels können an ein übergeordnetes System, zum Beispiel der dem Projektionssystem zugeordneten Steuervorrichtung, als Fehler gemeldet werden.

Gemäß einer weiteren Ausführungsform ist die Bildauswerteeinrichtung dazu eingerichtet, bei einem Muster mit fester Ortsfrequenz die Position des Spiegels ausschließlich aus einer Phase der Fouriertransformierten abzuleiten.

Hierdurch wird ein leichteres Bestimmen der Feinposition des Spiegels ermöglicht, da das Bestimmen der Ortsfrequenz des erfassten Musters im Amplitudenbild der Fouriertransformierten entfallen kann.

Gemäß einer weiteren Ausführungsform ist die Bildauswerteeinrichtung dazu eingerichtet, die Position des Spiegels mittels einer Radon-Transformierten zu bestimmen.

Eine Linie, insbesondere die dem periodischen Muster überlagerte Linie mit der vorbestimmten Steigung, ist der Radon-Transformierten eines erfassten Bildes einfacher zu entnehmen als dem erfassten Bild selbst. Eine solche Linie zeigt sich in der Radon-Transformierten des erfassten Bildes als ein Punkt (Θ, r) der Radon-Transformierten mit einem Maximalwert. Die Koordinaten dieses Punktes entsprechen dem Neigungswinkel Θ und der Position r der zu bestimmenden Linie. Die Position r ist ein Maß für die Absolut- oder Grobposition des Spiegels. Die Spalten der Radon-Transformation entsprechen Projektionen F(r) des aufgenommenen Bildes in Richtung Θ.

Gemäß einer weiteren Ausführungsform ist die Bildauswerteeinrichtung dazu eingerichtet, die Position des Spiegels mittels einer Radon-Transformierten unter Verwendung des Zentralschnitt-Theorems zu bestimmen.

Mittels des Zentralschnitt-Theorems ist die aus dem erfassten Bild aufwändig zu bestimmende Radon-Transformierte leichter aus einer bereits vorliegenden zweidimensionalen Fouriertransformierten entnehmbar. Gemäß dem Zentralschnitt-Theorem ist die eindimensionale Fouriertransformierte der Projektion F(r) einem Schnitt in der zweidimensionalen Fouriertransformierten des erfassten Bildes unter dem Winkel Θ zu entnehmen. Die zur Konstruktion der Radon-Transformierten benötigten Projektionen F(r) sind also mittels inverser Fourier-transformation in r Richtung aus der bereits vorliegenden, polarkoordinatentransformierten zweidimensionalen Fouriertransformierten des erfassten Bildes ermittelbar.

Die Radon-Transformation erfolgt insbesondere nur in kleinen Winkelbereichen um einen Nennwinkel des periodischen Musters, da eine als Zwischenschritt der Radon-Transformation erforderliche Polarkoordinatentransformation ein Auslesen von Subpixel-Grauwerten des erfassten Bildes erfordert, welches für eine digitale Bildauswertung nachteilig ist.

Gemäß einer weiteren Ausführungsform sind die Musterbereitstellungseinrichtung, die Bilderfassungseinrichtung und die Bildauswerteeinrichtung in einem Vakuum-Gehäuse angeordnet.

Ferner wird ein Projektionssystem einer Lithographieanlage vorgeschlagen. Das Projektionssystem weist eine Mehrzahl N1 von Spiegeln, welche eine Anzahl N2 von aktuierbaren Spiegeln umfasst, mit N2 ≤ N1, und eine Mehrzahl N3 der Positionssensorvorrichtungen auf, wobei jeweils eine Anzahl N4 von Positionssensorvorrichtungen einem der aktuierbaren Spiegeln zugeordnet sind, mit N3 = N4 - N2.

Die Mehrzahl N1 der Spiegel des Projektionssystems ist beispielsweise 6 (N1 = 6). Die Anzahl N2 der aktuierbaren Spiegel des Projektionssystems ist beispielsweise 5 (N2 = N1-1 = 6). Die Anzahl N4 der Projektionssensorvorrichtungen, welche einem jeden der N2 aktuierbaren Spiegel zugeordnet ist, ist beispielsweise sechs (N4 = 6; N3 = 30).

Gemäß einer Ausführungsform des Projektionssystems ist N2 ≤ N3 ≤ 6 • N2.

Gemäß dieser Ausführungsform werden nicht sechs Positionssensorvorrichtungen dem jeweiligen aktuierbaren Spiegel zugeordnet, sondern weniger. Dies ist möglich, da vorliegend bildbasierte Positionssensorvorrichtungen eingesetzt werden. Die vorliegenden bildbasierten Positionssensorvorrichtungen liefern umfassende Informationen über mehrere Freiheitsgrade. Damit ist es, insbesondere je nach Montageort der Positionssensorvorrichtungen, möglich, die sechs Freiheitsgrade mit weniger als sechs Positionssensorvorrichtungen zu messen. Damit können weniger Positionssensorvorrichtungen verbaut werden. Hierbei ergibt sich eine deutliche Kostenreduktion. Ferner reduzieren sich die Aufwände für die Montage. Beispielsweise können mit drei bildbasierten Positionssensorvorrichtungen die sechs Freiheitsgrade eines aktuierbaren Spiegels erfasst werden.

Die Lithographieanlage ist insbesondere eine EUV- oder DUV-Lithographieanordnung. EUV steht für "Extreme Ultraviolett" und bezeichnet eine Wellenlänge des Arbeitslichts zwischen 0,1 und 30 nm. DUV steht für "Deep Ultraviolett" und bezeichnet eine Wellenlänge des Arbeitslichts zwischen 30 und 250 nm.

Des Weiteren wird eine Lithographieanlage vorgeschlagen, welche ein wie oben beschriebenes Projektionssystem aufweist.

Ferner wird ein Verfahren zum Ermitteln einer Position zumindest eines Spiegels einer Lithographieanlage bereitgestellt. Dieses weist folgende Schritte auf: Bereitstellen eines mit dem Spiegel gekoppelten Musters, welches einen Informationsgehalt bei Ortsfrequenzen von zumindest 1/(500 µm) aufweist, Erfassen des bereitgestellten Musters mittels einer Bilderfassungseinrichtung, wobei die Bilderfassungseinrichtung eine Optik und einen Bildsensor aufweist, wobei die Optik dazu eingerichtet ist, das bereitgestellte Muster mit den Ortsfrequenzen von zumindest 1/(500 µm) mit einer Intensitätsabschwächung von höchstens 99 % auf den Bildsensor abzubilden, und Ermitteln der Position des Spiegels in Abhängigkeit von dem erfassten Muster.

Die für die vorgeschlagene Vorrichtung beschriebenen Ausführungsformen und Merkmale gelten für das vorgeschlagene Verfahren entsprechend.

Im Weiteren wird die Erfindung anhand von bevorzugten Ausführungsformen unter Bezugnahme auf die beigelegten Figuren näher erläutert.
Fig. 1 zeigt eine schematische Ansicht einer EUV-Lithographieanlage;
Fig. 2 zeigt eine schematische Ansicht einer Ausführungsform einer Positionssensorvorrichtung zum Ermitteln einer Position zumindest eines Spiegels der Lithographieanlage;
Fig. 3 zeigt eine schematische Ansicht einer Ausführungsform eines Projektionssystems mit zugeordneter Steuervorrichtung;
Fig. 4 zeigt eine Ausführungsform eines Musters (Sinusmuster) für eine Feinbestimmung einer Position eines Spiegels;
Fig. 5 zeigt eine Intensitätsverteilung zu dem Sinusmuster der Fig. 4;
Fig. 6 und 7 zeigen Simulationsergebnisse einer Positionssensorvorrichtung bei Aufnahme des Musters der Fig. 4;
Fig. 8 zeigt ein Beispiel eines Sinusmusters, welches gegenüber dem Sinusmuster der Fig. 4 gedreht und skaliert ist;
Fig. 9 zeigt eine zweidimensionale diskrete Fouriertransformierte (2D-DFT) zu dem verdrehten und skalierten Sinusmuster der Fig. 8;
Fig. 10 zeigt eine weitere Ausführungsform eines Musters für eine Feinbestimmung der Position des Spiegels;
Fig. 11 zeigt eine Intensitätsverteilung zu dem Muster der Fig. 10;
Fig. 12 zeigt eine weitere Ausführungsform eines Musters für eine Grobbestimmung und für eine Feinbestimmung der Position des Spiegels;
Fig. 13 zeigt eine weitere Ausführungsform eines Musters für eine Grobbestimmung und für eine Feinbestimmung der Position des Spiegels;
Fig. 14 zeigt eine Radon-Transformierte eines Bildausschnitts der Fig. 13; und
Fig. 15 zeigt eine Ausführungsform eines Verfahrens zum Ermitteln einer Position zumindest eines Spiegels der Lithographieanlage.

In den Figuren sind gleiche oder funktionsgleiche Elemente mit denselben Bezugszeichen versehen worden, sofern nichts anderes angegeben ist. Ferner sollte beachtet werden, dass die Darstellungen in den Figuren nicht notwendigerweise maßstabsgerecht sind.

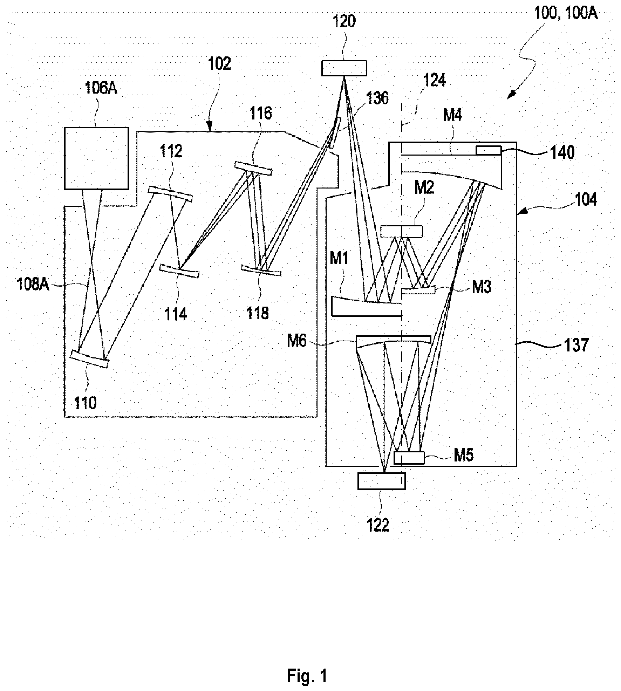

Fig. 1 zeigt eine schematische Ansicht einer EUV-Lithographieanlage 100A, welche ein Strahlformungs- und Beleuchtungssystem 102 und ein Projektionssystem 104 umfasst. Dabei steht EUV für "extremes Ultraviolett" (Engl.: extreme ultraviolet, EUV) und bezeichnet eine Wellenlänge des Arbeitslichts zwischen 0,1 und 30 nm. Das Strahlformungs- und Beleuchtungssystem 102 und das Projektionssystem 104 sind jeweils in einem Vakuum-Gehäuse vorgesehen, wobei jedes Vakuum-Gehäuse mit Hilfe einer nicht näher dargestellten Evakuierungsvorrichtung evakuiert wird. Die Vakuum-Gehäuse sind von einem nicht näher dargestellten Maschinenraum umgeben, in welchem z.B. elektrische Steuerungen und dergleichen vorgesehen sind.

Die EUV-Lithographieanlage 100A weist eine EUV-Lichtquelle 106A auf. Als EUV-Lichtquelle 106A kann beispielsweise eine Plasmaquelle vorgesehen sein, welche Strahlung 108A im EUV-Bereich (extrem ultravioletten Bereich), also z.B. im Wellenlängenbereich von 5 nm bis 30 nm aussendet. Im Strahlformungs- und Beleuchtungssystem 102 wird die EUV-Strahlung 108A gebündelt und die gewünschte Betriebswellenlänge aus der EUV-Strahlung 108A herausgefiltert. Die von der EUV-Lichtquelle 106A erzeugte EUV-Strahlung 108A weist eine relativ niedrige Transmissivität durch Luft auf, weshalb die Strahlführungsräume im Strahlformungs- und Beleuchtungssystem 102 und im Projektionssystem 104 evakuiert sind.

Das in Fig. 1A dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 108A auf die Photomaske (Engl.: reticle) 120 geleitet. Die Photomaske 120 ist ebenfalls als reflektives optisches Element ausgebildet und kann außerhalb der Systeme 102, 104 angeordnet sein. Weiter kann die EUV-Strahlung 108A mittels eines Spiegels 136 auf die Photomaske gelenkt werden. Die Photomaske 120 weist eine Struktur auf, welche mittels des Projektionssystems 104 verkleinert auf einen Wafer 122 oder dergleichen abgebildet wird.

Das Projektionssystem 104 weist sechs Spiegel M1 - M6 zur Abbildung der Photomaske 120 auf den Wafer 122 auf. Dabei können einzelne Spiegel M1 - M6 des Projektionssystems 104 symmetrisch zur optischen Achse 124 des Projektionssystems 104 angeordnet sein. Es sollte beachtet werden, dass die Anzahl der Spiegel der EUV-Lithographieanlage 100A nicht auf die dargestellte Anzahl beschränkt ist. Es können auch mehr oder weniger Spiegel vorgesehen sein. Des Weiteren sind die Spiegel M1 - M6 i.d.R. an ihrer Vorderseite zur Strahlformung gekrümmt.

Das Projektionssystem 104 weist ferner eine Anzahl von Positionssensorvorrichtungen 140 zur Ermittlung einer Position eines der Spiegel M1 - M6 auf. Ohne Einschränkung der Allgemeinheit und aus Gründen der vereinfachten Darstellung zeigt Fig. 1 eine Positionssensorvorrichtung 140.

Unter der bespielhaften Annahme, dass das Projektionssystem 104 sechs Spiegel (N1 = 6) aufweist, von denen fünf Spiegel aktuierbar sind (N2 = 5) und jeder der aktuierbaren Spiegel sechs Positionssensorvorrichtungen (N4 = 6) zuzuordnen sind, ergibt sich eine Anzahl N3 der Positionssensorvorrichtungen 140 in dem Projektionssystem 104 von 30 (N3 = N4 • N2 = 6 - 5 = 30).

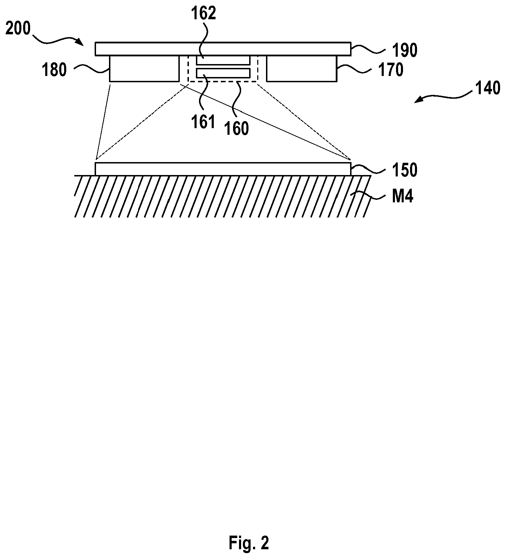

Details zu der Positionssensorvorrichtung 140 sind mit Bezug zu den Fig. 2 bis 14 näher beschrieben.

Hierzu zeigt die Fig. 2 eine schematische Ansicht einer Ausführungsform einer Positionssensorvorrichtung 140 zum Ermitteln einer Position eines Spiegels der Lithographieanlage, zum Beispiel des Spiegels M4 des Projektionssystems 104 der Lithographieanlage 100.

Die Positionssensorvorrichtung 140 der Fig. 2 umfasst eine Musterbereitstellungseinrichtung 150, eine Bilderfassungseinrichtung 160 und eine Bildauswerteeinrichtung 170. Die Positionssensorvorrichtung 140 kann auch als bildbasierte Positionssensorvorrichtung 140 oder als bildbasierter Positionssensor bezeichnet werden.

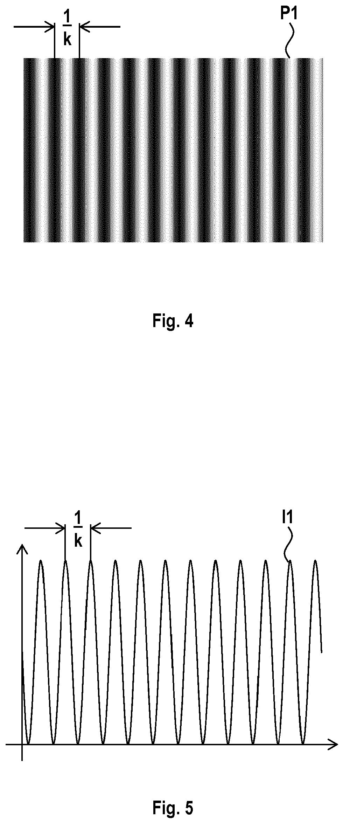

Die Musterbereitstellungseinrichtung 150 ist mit dem Spiegel M4 gekoppelt, zum Beispiel am Rand des Spiegels M4 mechanisch befestigt. Die Musterbereitstellungseinrichtung 150 ist dazu eingerichtet, ein Muster P1 - P5 (siehe Fig. 4, 6, 7, 8 und 9) bereitzustellen, wobei das Muster P1 - P5 einen Informationsgehalt bei Ortsfrequenzen von zumindest 1/(500 µm) aufweist. Die Bilderfassungseinrichtung 160 ist zur Erfassung des von der Musterbereitstellungseinrichtung 150 bereitgestellten Musters P1 - P5 eingerichtet. Die Bilderfassungseinrichtung 160 weist beispielsweise eine Optik 161 und einen Bildsensor 162 auf. Die Optik 161 ist dazu eingerichtet, das bereitgestellte Muster P1 - P5 mit den Ortsfrequenzen von zumindest 1/(500 µm) mit einer Intensitätsabschwächung von höchstens 99% auf den Bildsensor 162 abzubilden.

Der Bildsensor 162 und die Bildauswerteeinrichtung 170 sind insbesondere in einer integrierten Baugruppe 200, insbesondere in einer einzigen integrierten Baugruppe 200, vorgesehen. Die integrierte Baugruppe 200 enthält beispielsweise ein FPGA oder ein ASIC. Die integrierte Baugruppe 200 umfasst eine Trägerleiterplatte 190, auf welcher die Bilderfassungseinrichtung 160 (zumindest teilweise), die Bildauswerteeinrichtung 170 und vorzugsweise eine Lichtquelle 180 zur Bestrahlung der Musterbereitstellungseinrichtung 150 mit einem Lichtstrahl angeordnet sind. Die Lichtquelle 180 ist insbesondere auch auf der Trägerleiterplatte 190 angeordnet. Die Trägerleiterplatte 190 ist beispielsweise aus Keramik gefertigt. Auf der Trägerleiterplatte 190 können ferner Abblockkondensatoren (nicht gezeigt) angeordnet sein. Die Abblockkondensatoren sind insbesondere mit einer gegen Ausgasung schützenden Schicht versehen.

Der Bildsensor 162 umfasst insbesondere eine Kamera, beispielsweise eine Ein-Objektiv-Kamera oder eine Multi-Apertur-Kamera. Alternativ kann der Bildsensor 162 auch eine Kamera mit einem Linsen-Array umfassen. Eine solche Kamera mit einem Linsen-Array ist besonders vorteilhaft für eine Mikrointegration. Des Weiteren kann der Bildsensor 162 auch eine plenoptische Kamera umfassen.

Die Musterbereitstellungseinrichtung 150 ist insbesondere dazu eingerichtet, das Muster P1 - P5 mit einem periodischen Muster bereitzustellen, welches einen Informationsgehalt bei Ortsfrequenzen von zumindest 1/(500 µm) aufweist. Beispiele für solche periodischen Muster sind in den Fig. 4, 8, 10, 12 und 13 dargestellt. Das periodische Muster P1 - P5 kann beispielsweise ein Sinusmuster P1, P2, P4, ein Rechteckmuster oder ein Chirp-Signalmuster P3, P5 sein. Beispielsweise umfasst die Musterbereitstellungseinrichtung 150 einen Rahmen (nicht gezeigt), welcher mit dem Spiegel M4 gekoppelt ist, und das auf dem Rahmen angeordnete oder befestigte Muster P1 - P5.

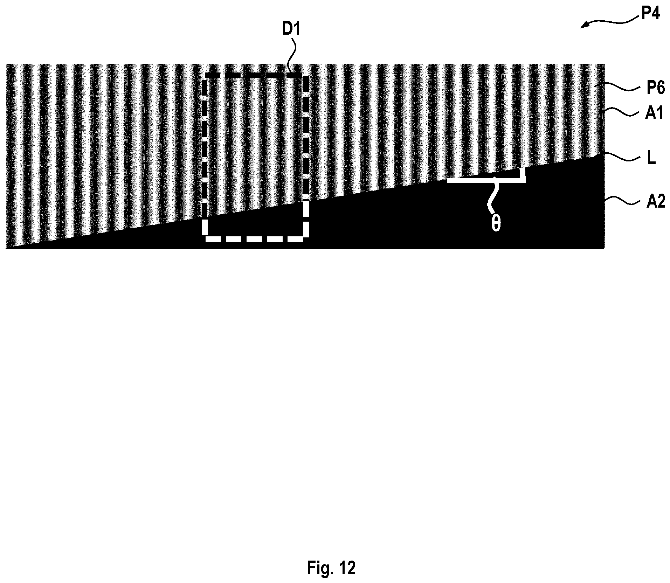

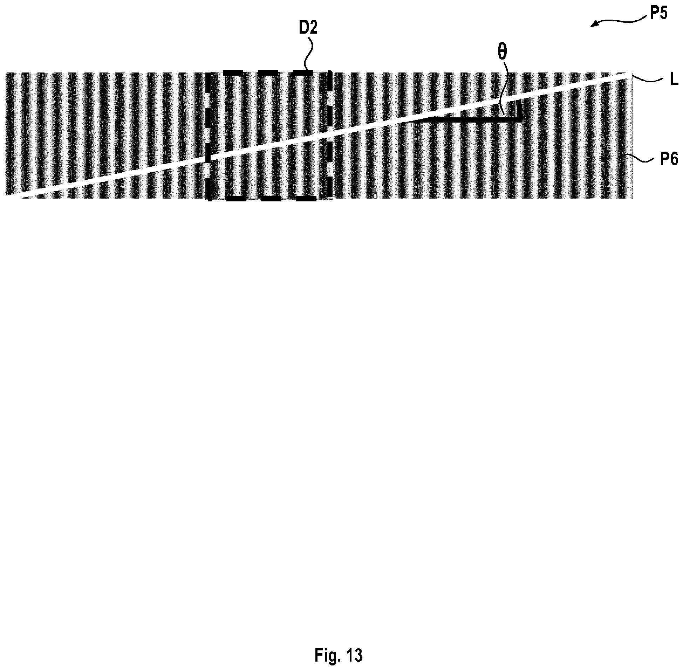

Ferner kann die Musterbereitstellungseinrichtung 150 dazu eingerichtet werden, das Muster P4, P5 mit einer Linie L mit einer vorbestimmten Steigung Θ für eine Grobbestimmung der Position des Spiegels M4 und mit einem periodischen Muster P6 für eine Feinbestimmung der Position des Spiegels M4, welches Informationsgehalt bei der Ortsfrequenz von zumindest 1/(500 µm) aufweist, bereitzustellen. Beispiele für solche Muster P4, P5 sind in den Fig. 12 und 13 dargestellt und werden im Folgenden näher erläutert.

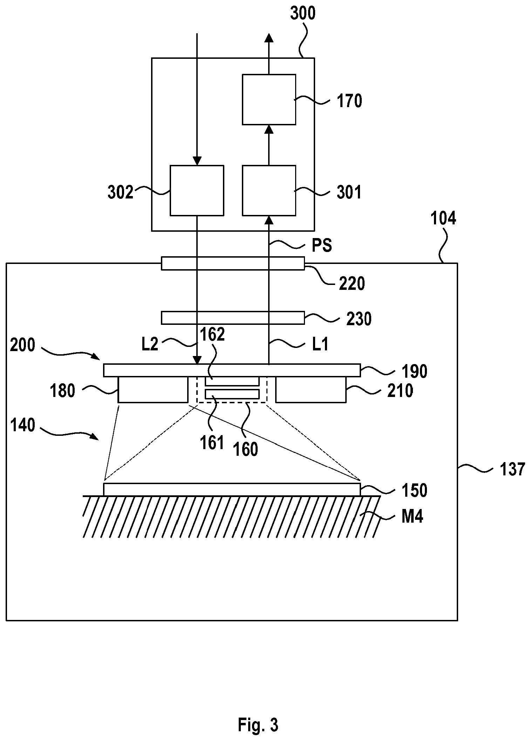

Fig. 3 zeigt eine schematische Ansicht einer Ausführungsform eines Projektionssystems 104 mit zugeordneter Steuervorrichtung 300. Die in Fig. 3 dargestellte Positionssensorvorrichtung 140 unterscheidet sich von der Ausführungsform der Fig. 2 insbesondere dahingehend, dass die Bildauswerteeinrichtung 170 nicht in dem Vakuumgehäuse 137 des Projektionssystems 104 angeordnet ist, sondern in der dem Projektionssystem 104 zugeordneten Steuervorrichtung 300 integriert ist.

Ferner zeigt die Fig. 3 eine auf der Trägerleiterplatte 190 angeordnete Steuereinheit 210, welche beispielsweise als FPGA oder als ASIC ausgebildet ist. Die Steuereinheit 210 kann auch einen Lichtquellentreiber für die Lichtquelle 180 umfassen. Des Weiteren kann die Steuereinheit 210 Mittel aufweisen, mittels denen das erfasste Muster P1 - P5 vorverarbeitet wird. Beispielsweise kann die Steuereinheit 210 ein vorverarbeitetes elektrisches Bildsignal PS aus dem von der Bilderfassungseinrichtung 160 erfassten Muster P1 - P5 erzeugen. Das Bildsignal oder Positionssignal PS wird dann über eine Vakuum-Durchkontaktierungsvorrichtung 220, über einen Steckverbindungssockel 230 und eine Datenleitung L1 an die Steuervorrichtung 300 übertragen.

Die Steuervorrichtung 300 umfasst insbesondere einen Protokolldecoder 301 zum Decodieren des Stroms von Bildsignalen oder Positionssignalen PS von der Steuereinheit 210. Die dem Protokolldecoder 301 nachgeordnete Bildauswerteeinrichtung 170 wertet den decodierten Bildstrom zur Ermittlung der Position des Spiegels M4 aus.

Des Weiteren umfasst die Steuervorrichtung 300 eine Energieversorgungsvorrichtung 302, welche zur elektrischen Energieversorgung mit der elektronischen Baugruppe 200, welche in dem Vakuumgehäuse 137 des Projektionssystems 104 angeordnet ist, verbunden ist.

Wie Fig. 3 illustriert, sind nur zwei Leitungen L1, L2 durch die Vakuum-Durchkontaktierungsvorrichtung 220 durchgeführt, nämlich die Datenleitung L1 zum Transport der Bildsignale oder Positionssignale PS an die Steuervorrichtung 300 und eine Energieleitung L2 zum Transport elektrischer Energie von der Energieversorgungsvorrichtung 302 zu der integrierten Baugruppe 200.

Fig. 4 zeigt eine erste Ausführungsform eines Musters P1 für eine Feinbestimmung einer Position eines Spiegels M4.

Das Muster P1 der Fig. 4 ist ein Sinusmuster und weist einen Informationsgehalt bei Ortsfrequenzen von zumindest 1/(500 µm) auf. Hierzu zeigt die Fig. 5 eine Intensitätsverteilung I1 zu dem Sinusmuster P1 der Fig. 4.

Die räumliche Periodenlänge ist 1/k und die Ortsfrequenz ist k. Beispielsweise beträgt die räumliche Periodenlänge 32 µm (1/k = 32 µm).

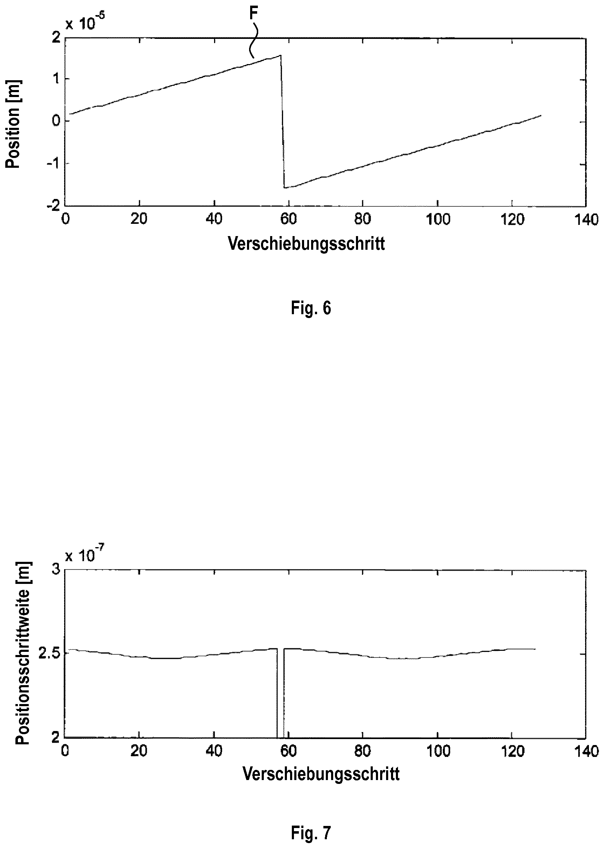

Die Fig. 6 und 7 zeigen Simulationsergebnisse einer Positionssensorvorrichtung 140 bei Aufnahme des Musters P1 der Fig. 4.

Die Simulationsergebnisse unterliegen folgenden Annahmen: Die räumliche Periodenlänge 1/k in dem Muster P1 der Fig. 4 ist 32 (1/k = 32). Die Abtastperiode ist 4 µm. Die Bildbreite entspricht bei 64 Pixel dann 64 • 4 µm = 256 µm in der Fig. 4. Die Bildgröße beträgt 64 • 32 Pixel der Bilderfassungseinrichtung 160. Die Simulationsergebnisse der Fig. 6 und 7 ergeben sich bei 128 Verschiebungsschritten zu je 4/16 µm (4/16 µm = 0,25 µm). Jeweils über den 128 Verschiebungsschritten illustriert die Fig. 6 die Position in µm, welche zwischen -16 µm und +16 µm liegt, und die Fig. 7 zeigt den Positionsschritt, der regelmäßig 0,25 µm beträgt.

In den Fig. 6 und 7 ist zu erkennen, dass der Positionssensor 140 die vorgegebene Feinposition F richtig erfasst. Ähnlich wie bei einem Encoder ist aufgrund der Mehrdeutigkeit des Sinusmusters auch ein Phasensprung (bei Schritt 58) zu erkennen. Die Schritte von 0,25 µm werden gemäß Vorgabe gemessen (siehe Fig. 7). Der Verlauf der Positionsschritte der Fig. 7 müsste - abgesehen vom Phasensprung bei Verschiebungsschritt 58 - konstant bei 0,25 µm sein. Dort sind systematische Fehler zu beobachten, die sich durch den Bilderzeugungsprozess in der Simulation erklären lassen. Da diese Effekte reproduzierbar sind, sind sie kalibrierbar und können daher herausgerechnet werden.

In der Realität bewegt sich das Muster P1 oder das Referenzmuster relativ zu der Bilderfassungseinrichtung 160, insbesondere der Kamera, so dass neben der zu messenden Bewegung auch Maßstabsänderungen, zum Beispiel eine Skalierung des Sinusmusters, und/oder eine geringe Rotation der Bilderfassungseinrichtung 160 auftreten können. Bei Encodern, welche auf einfacher eindimensionaler Signalverarbeitung beruhen, kann dies zu Messfehlern führen. Beim vorliegenden bildbasierten Positionssensor 140 können diese Effekte bei der Detektierung kompensiert werden oder bei zu starken Störungen an ein übergeordnetes System, beispielsweise der Steuervorrichtung 300 des Projektionssystems 104, als Fehler gemeldet werden.

Die Signalauswertung kann dabei so durchgeführt werden, dass die Lage der Grundfrequenzen des Sinusmusters nicht mehr als fest angenommen wird. Die Grundfrequenz des Sinusmusters kann dann durch die Bildverarbeitung detektiert werden, indem die Maximalwerte im 2D Betragsspektrum des Kamerabildes lokalisiert werden. Eine Skalierung des Musters, zum Beispiel durch eine Abstandsänderung, äußert sich in einer umgekehrten Skalierung in der zweidimensionalen diskreten Fourier-Transformation (2D-DFT). Eine Rotation führt zu einer entsprechenden Rotation der zweidimensionalen diskreten Fourier-Transformation (2D-DFT).

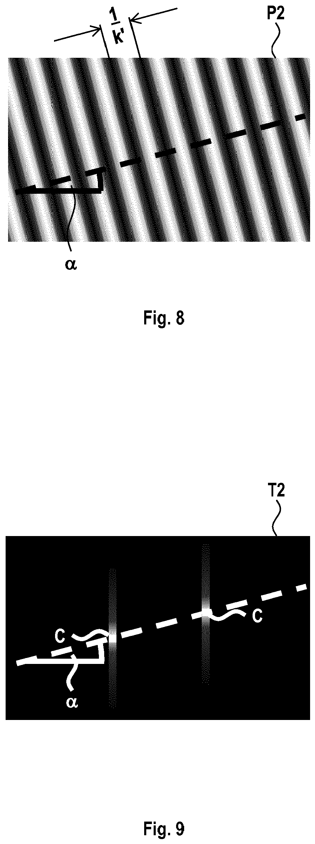

Hierzu zeigt die Fig. 8 ein Beispiel eines Sinusmusters P2, welches gegenüber dem Sinusmuster P1 der Fig. 4 um einen Winkel α gedreht ist und um den Faktor 1.1 skaliert ist. Die Skalierung des Sinus führt dazu, dass das Bild in x-Richtung bzw. y-Richtung nicht mehr periodisch ist, wenn mehrere Instanzen nebeneinander kopiert gedacht werden. Dies führt zu einer Verwaschung der Maximalwerte C in der 2D-DFT der Fig. 9 aufgrund eines Leck-Effekts, wobei die Lage der Maximalwerte C zueinander aber nicht beeinflusst wird.

Wie oben dargestellt, sind die Muster P1 und P2 der Fig. 4 und 8 Sinusmuster. Als Alternative können auch Rechteckmuster verwendet werden. Rechteckmuster haben den Vorteil, industriell einfach und damit mit geringeren Kosten hergestellt werden zu können. Das Rechteckmuster besteht beispielsweise ausschließlich aus Schwarz-Weiß-Streifen. In der 2D-DFT sind dann zum Beispiel Oberschwingungen und damit weitere Maximalwerte, sogenannte Peaks, zu sehen. Durch eine angepasste Bildverarbeitung in der Bildauswerteeinrichtung 170 kann die Phasenmessung aber zum Beispiel auf die Grundfrequenz eingeschränkt werden. Auch geringfügige Fokusänderungen stören den Positionssensor 140 nicht, solange die Peaks im 2D Betragsspektrum des Kamerabildes gut (für die Bildverarbeitung) erkennbar sind. Wenn die Fokusänderung aber so weit geht, dass ein Tiefpasseffekt durch die Unschärfe die Peak-Höhe in der 2D-DFT reduziert, kann erhöhtes Rauschen des bildbasierten Positionssensors 140 auftreten. Aufgrund der reduzierten Peak-Höhe kann die Lokalisierung des Peaks rauschbehafteter werden. Damit wird dann auch die Phase einer mehr rauschbehafteten Stelle ausgelesen. Dies kann dazu führen, dass die gemessene Phase und damit die gemessene Position des Referenzmusters P2 rauschbehafteter werden. Eine solche Defokussierung kann allerdings auch gezielt eingesetzt werden, um bei der Bildaufnahme ein Anti-Aliasing zu erreichen.

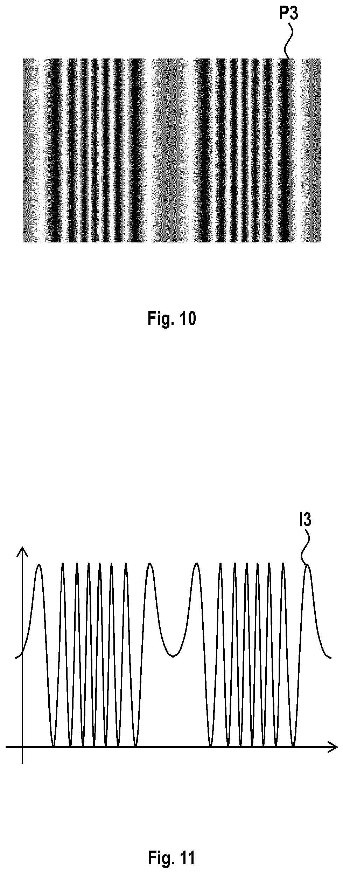

Fig. 10 zeigt eine weitere Ausführungsform eines Musters P3 für die Feinbestimmung der Position des Spiegels M4. Das Muster P3 der Fig. 10 ist ein so genanntes Chirp-Signalmuster oder Chirp-Muster. Eine Intensitätsverteilung I3 eines solchen Chirp-Musters P3 ist in der Fig. 11 dargestellt.

Das Chirp-Signal I3 der Fig. 11, welches sich infolge des Musters P3 der Fig. 10 ergibt, kann vorteilhaft durch die Bildauswerteeinrichtung 170 ausgewertet werden. Im Besonderen lässt sich die Verschiebung relativ zu einer Referenzposition sehr genau bestimmen. Hierfür sind Korrelationsverfahren gut geeignet. Auch die Bestimmung von Verdrehungen und Skalierungen sind bei der Verwendung eines Chirp-Signals I3 möglich. Allerdings kann hier die Rechenkomplexität ansteigen. Bei Korrelation könnte zum Beispiel eine volle Suche im Parameterraum durchgeführt werden. Das heißt, die Korrelationsfunktion, in welcher das Maximum zu lokalisieren ist, wäre nicht nur über die x-Verschiebung zu berechnen und auszuwerten, sondern über die x-Verschiebung, die Skalierung und die Rotation. Diese Berechnung wäre rechenintensiver, im Besonderen wenn auch noch Verschiebungen in der y-Achse mit berücksichtigt werden sollen. Demnach sind Chirp-Signale I3 vor allem dann besonders geeignet, wenn die Bewegung des Musters sehr genau nur in der x-Richtung stattfindet und keine großen parasitären Bewegungen auftreten können.

Wie oben ausgeführt, sind die vorgenannten Muster P1 - P3 für eine Feinbestimmung der Position geeignet. Damit kann die Bildauswerteeinrichtung 170 mittels der Muster P1 - P3 eine genaue, aber mehrdeutige Bestimmung der Position ermöglichen.

Wie eingangs schon ausgeführt, kann die Musterbereitstellungseinrichtung 150 aber auch dazu eingerichtet werden, ein Muster P4, P5 mit einer Linie L mit einer vorbestimmten Steigung Θ für eine Grobbestimmung der Position des Spiegels M4 und mit einem periodischen Muster P6 für eine Feinbestimmung der Position des Spiegels bereitzustellen.

Die Fig. 12 zeigt ein Beispiel eines solchen Musters P4 mit einer Linie L und einem periodischen Muster P6.

In der Ausführungsform der Fig. 12 hat das Muster P4 einen ersten Musteranteil A1, in welchem das periodische Muster P6 angeordnet ist, und einen zweiten Musteranteil A2, in welchem die Linie L mit der vorbestimmten Steigung Θ angeordnet ist. Der erste Musteranteil A1 und der zweite Musteranteil A2 sind insbesondere getrennt voneinander.

Des Weiteren ist in der Fig. 12 ein Bildausschnitt D1 der Bilderfassungseinrichtung 160 dargestellt.

Die Absolutmessung oder Grobmessung erfolgt insbesondere dadurch, dass die Bildauswerteeinrichtung 170 feststellt, wie weit das periodische Muster P6 nach unten, d.h. auf die Linie L, reicht.

Eine Alternative zum Muster P4 der Fig. 12 zeigt das Muster P5 der Fig. 13. In dem Muster P5 der Fig. 13 ist die Linie L mit der vorbestimmten Steigung Θ dem periodischen Muster P6 überlagert. Das Muster P5 der Fig. 13 nutzt mehr Fläche für die Feinbestimmung als das Muster P4 der Fig. 12 und stellt damit im Allgemeinen ein verbessertes Signalrauschverhältnis bereit. In der Fig. 13 ist der Bildausschnitt der Bilderfassungseinrichtung 160 mit D2 bezeichnet.

Die Auswertung des Musters P5 der Fig. 13 kann über eine Radon-Transformation erfolgen.

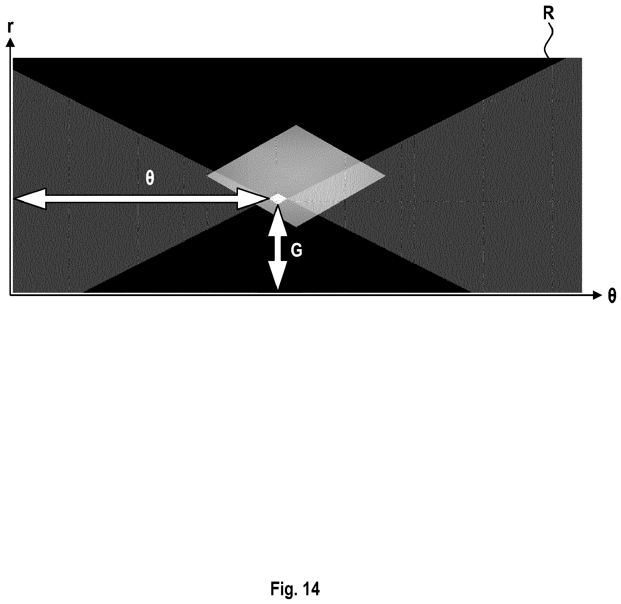

Hierzu zeigt die Fig. 14 die Radon-Transformierte R des Bildausschnitts D2 der Fig. 13. Die Höhe des Punktes in der Radon-Transformierten R repräsentiert die Absolutposition G. Die Position des Punktes in Winkelrichtung repräsentiert den Winkel Θ der Linie L des Musters P5 der Fig. 13.

Insbesondere kann die Bildauswerteeinrichtung 140 auch dazu eingerichtet sein, die Position des Spiegels M4 mittels der Radon-Transformierten R unter Verwendung des Zentralschnitt-Theorems zu bestimmen. Durch die Anwendung des Zentralschnitt-Theorems kann die Berechnung der Radon-Transformierten R vereinfacht werden. Die Polarkoordinatentransformation als Zwischenschritt der Radon-Transformation erfordert das Auslesen von Subpixel-Grauwerten. Da die Orientierung des Sinusmusters für die Feinpositionsmessung und die Orientierung der Linie für die Messung der Absolutposition bekannt sind, kann die Radon-Transformierte R auch nur für kleine Winkelbereiche um den Nennwinkel des Sinusmusters P6 und der Linie L für die Absolutmessung berechnet werden. Insbesondere können auch die beiden Nennwinkel ausreichen. Um aber auch parasitäre Bewegungen des Musters P5 zu erfassen, ist die Berechnung in kleinen Winkelbereichen um die Nennwinkel bevorzugt.

Bei der Berechnung der Radon-Transformierten R unter Nutzung des Zentralschnitt-Theorems ergibt sich das eindimensionale Signal zur Phasenauswertung des Sinusmusters P6 für die Feinmessung als Zwischenergebnis und muss demnach nicht extra berechnet werden. Unter Nutzung des Zentralschnitt-Theorems kann die Radon-Transformierte folgendermaßen berechnet werden: i) Berechnung der zweidimensionalen diskreten Fourier-Transformierten, beispielsweise über die zweidimensionale Fast-Fourier-Transformierte; ii) Polarkoordinatentransformation; und iii) 1D IFFT (Inverse Fast Fourier Transformation) in Radiusrichtung.

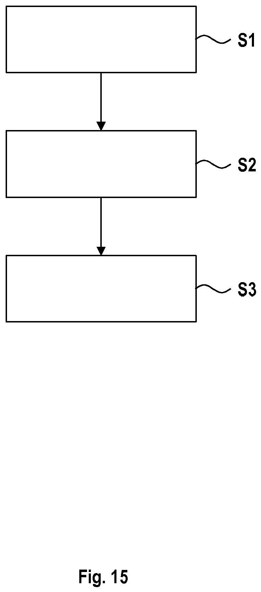

Ferner wird ein Verfahren zum Ermitteln einer Position zumindest eines Spiegels M4 einer Lithographieanlage 100 dargestellt. Das Verfahren der Fig. 15 weist folgende Schritte S1 bis S3 auf:
Im Schritt S1 wird ein mit dem Spiegel gekoppeltes Muster bereitgestellt, welches einen Informationsgehalt bei Ortsfrequenzen von zumindest 1/(500 µm) aufweist.
Im Schritt S2 wird das bereitgestellte Muster mittels einer Bilderfassungseinrichtung erfasst.
Im Schritt S3 wird die Position des Spiegels in Abhängigkeit von dem erfassten Muster ermittelt.

Obwohl die vorliegende Erfindung anhand von Ausführungsbeispielen beschrieben wurde, ist sie vielfältig modifizierbar. Die Erfindung wird durch die Ansprüche definiert.

### BEZUGSZEICHENLISTE

- 100: Lithographieanlage
- 100A: EUV-Lithographieanlage
- 102: Strahlformungs- und Beleuchtungssystem
- 104: Projektionssystem
- 106A: EUV-Lichtquelle
- 108A: EUV-Strahlung
- 110: Spiegel
- 112: Spiegel
- 114: Spiegel
- 116: Spiegel
- 118: Spiegel
- 120: Photomaske
- 122: Wafer
- 124: optische Achse des Projektionssystems
- 136: Spiegel
- 137: Vakuum-Gehäuse
- 140: Positionssensorvorrichtung
- 150: Musterbereitstellungseinrichtung
- 160: Bilderfassungseinrichtung
- 161: Optik
- 162: Bildsensor
- 170: Bildauswerteeinrichtung
- 180: Lichtquelle
- 190: Trägerleiterplatte
- 200: integrierte Baugruppe
- 210: Steuereinheit
- 220: Vakuum-Durchkontaktierungsvorrichtung
- 230: Steckverbindungssockel
- 300: Steuervorrichtung
- 301: Protokolldecoder
- 302: Energieversorgungsvorrichtung

- A1: erster Musteranteil
- A2: zweiter Musteranteil
- α: Neigungswinkel des Musters
- C: Maximalwert einer Amplitude der zweidimensionalen Fouriertransformierten
- D1, D2: Bildausschnitt der Bilderfassungseinrichtung
- F: Feinposition
- G: Grobposition des Spiegels
- I1: Intensitätsfunktion des Sinusmusters
- I3: Intensitätsfunktion des Chirpmusters
- k: Ortsfrequenz
- k': skalierte Ortsfrequenz
- 1/k: räumliche Periodenlänge
- L: Linie
- L1: Datenleitung
- L2: Spannungsleitung
- M1-M6: Spiegel
- PS: Positionssignal
- P1: Sinusmuster
- P2: skaliertes und verdrehtes Sinusmuster
- P3: Chirpmuster
- P1-P5: Muster
- P6: periodisches Muster
- r: Radius
- R: Radon-Transformierte
- S1-S3: Verfahrensschritte
- T2: zweidimensionale Fouriertransformierte
- Θ: Neigungswinkel des zweiten Musteranteils

## Patentansprüche

1. Positionssensorvorrichtung (140) zum Ermitteln einer Position zumindest eines Spiegels (M1 - M6) einer Lithographieanlage (100), aufweisend:
eine mit dem Spiegel (M4) gekoppelte Musterbereitstellungseinrichtung (150) zur Bereitstellung eines Musters (P1 - P5), welches einen Informationsgehalt bei Ortsfrequenzen von zumindest 1/(500 µm) aufweist,
eine Bilderfassungseinrichtung (160) zur Erfassung des bereitgestellten Musters (P1 - P5), wobei die Bilderfassungseinrichtung (160) eine Optik (161) und einen Bildsensor (162) aufweist, wobei die Optik (161) dazu eingerichtet ist, das bereitgestellte Muster (P1 - P5) mit den Ortsfrequenzen von zumindest 1/(500 µm) mit einer Intensitätsabschwächung von höchstens 99 % auf den Bildsensor (162) abzubilden, und
eine Bildauswerteeinrichtung (170) zur Ermittlung der Position des Spiegels (M4) in Abhängigkeit von dem erfassten Muster (P1 - P5).

2. Positionssensorvorrichtung gemäß Anspruch 1, wobei der Bildsensor (162) und die Bildauswerteeinrichtung (170) in derselben integrierten Baugruppe (200) vorgesehen sind.

3. Positionssensorvorrichtung gemäß Anspruch 1 oder 2, wobei die Musterbereitstellungseinrichtung (150) dazu eingerichtet ist, das Muster (P4, P5) mit einem ersten Musteranteil für eine Grobbestimmung der Position des Spiegels (M4) und mit einem zweiten Musteranteil für eine Feinbestimmung der Position des Spiegels (M4) bereitzustellen, wobei der zweite Musteranteil einen Informationsgehalt bei Ortsfrequenzen von zumindest 1/(500 µm) aufweist.

4. Positionssensorvorrichtung gemäß einem der Ansprüche 1 bis 3, wobei die Musterbereitstellungseinrichtung (150) dazu eingerichtet ist, das Muster (P1 - P5) mit einem periodischen Muster bereitzustellen, welches einen Informationsgehalt bei Ortsfrequenzen von zumindest 1/(500 µm) aufweist.

5. Positionssensorvorrichtung gemäß Anspruch 1 oder 2, wobei die Musterbereitstellungseinrichtung (150) dazu eingerichtet ist, das Muster (P4, P5) mit einer Linie (L) mit einer vorbestimmten Steigung (Θ) für eine Grobbestimmung der Position des Spiegels (M4) und mit einem periodischen Muster (P6) für eine Feinbestimmung der Position des Spiegels (M4), welches einen Informationsgehalt bei Ortsfrequenzen von zumindest 1/(500 µm) aufweist, bereitzustellen.

6. Positionssensorvorrichtung gemäß Anspruch 5, wobei die Musterbereitstellungseinrichtung (150) dazu eingerichtet ist, das Muster (P4) mit einem ersten Musteranteil (A1), in welchem das periodische Muster (P6) angeordnet ist, und mit einem von dem ersten Musteranteil (A1) getrennten, zweiten Musteranteil (A2), in welchem die Linie (L) mit der vorbestimmten Steigung (Θ) angeordnet ist, bereitzustellen.

7. Positionssensorvorrichtung gemäß Anspruch 5, wobei die Musterbereitstellungseinrichtung (150) dazu eingerichtet ist, das Muster (P5) derart bereitzustellen, dass die Linie (L) mit der vorbestimmten Steigung (Θ) dem periodischen Muster (P6) überlagert ist.

8. Positionssensorvorrichtung gemäß einem der Ansprüche 4 bis 7, wobei das periodische Muster (P1 - P5) ein Sinusmuster (P1, P2, P4, P5), ein Rechteckmuster oder ein Chirpsignalmuster (P3) ist.

9. Positionssensorvorrichtung gemäß einem der Ansprüche 1 bis 8, wobei die Bildauswerteeinrichtung (170) dazu eingerichtet ist, die Position des Spiegels (M4) mittels einer Fouriertransformation (T2), insbesondere mittels einer diskreten Fouriertransformation, des erfassten Musters (P2) zu bestimmen.

10. Positionssensorvorrichtung gemäß Anspruch 9, wobei die Bildauswerteeinrichtung (170) dazu eingerichtet ist, eine Ortsfrequenz des erfassten Musters (P2) aus einem Maximalwert (C) einer Amplitude der Fouriertransformierten (T2) abzuleiten und eine Verschiebung des Musters (P2) zu einer Referenzposition aus einer Phase der Fouriertransformierten (T2) bei der abgeleiteten Ortsfrequenz abzuleiten.

11. Positionssensorvorrichtung gemäß Anspruch 9, wobei die Bildauswerteeinrichtung (170) dazu eingerichtet ist, bei einem Muster mit fester Ortsfrequenz die Position des Spiegels ausschließlich aus einer Phase der Fouriertransformierten (T2) abzuleiten.

12. Positionssensorvorrichtung gemäß einem der Ansprüche 1 bis 8, wobei die Bildauswerteeinrichtung (170) dazu eingerichtet ist, die Position des Spiegels (M4) mittels einer Radon-Transformierten (R) zu bestimmen.

13. Positionssensorvorrichtung gemäß einem der Ansprüche 1 bis 8, wobei die Bildauswerteeinrichtung (170) dazu eingerichtet ist, die Position des Spiegels (M4) mittels einer Radon-Transformierten (R) unter Verwendung des Zentralschnitt-Theorems zu bestimmen.

14. Positionssensorvorrichtung gemäß einem der Ansprüche 1 bis 13, wobei die Musterbereitstellungseinrichtung (150), die Bilderfassungseinrichtung (160) und die Bildauswerteeinrichtung (170) in einem Vakuum-Gehäuse (137) angeordnet sind.

15. Projektionssystem (104) einer Lithographieanlage (100), aufweisend:
eine Mehrzahl N von Spiegeln (M1- M6), welche eine Anzahl M von aktuierbaren Spiegeln umfasst, mit M ≤ N, und
eine Mehrzahl X von Positionssensorvorrichtungen (140) gemäß einem der Ansprüche 1 bis 14.

16. Projektionssystem gemäß Anspruch 15, wobei M ≤ X ≤ 6 · M ist.

17. Projektionssystem gemäß Anspruch 15 oder 16, wobei jeweils sechs Positionssensorvorrichtungen (140) einem der aktuierbaren Spiegeln zugeordnet sind, mit X = 6 -M.

18. Lithographieanlage (100), aufweisend ein Projektionssystem (140) gemäß einem der Ansprüche 15 bis 17.

19. Verfahren zum Ermitteln einer Position zumindest eines Spiegels einer Lithographieanlage, aufweisend:
Bereitstellen eines mit dem Spiegel gekoppelten Musters, welches einen Informationsgehalt bei Ortsfrequenzen von zumindest 1/(500 µm) aufweist,
Erfassen des bereitgestellten Musters mittels einer Bilderfassungseinrichtung (160), wobei die Bilderfassungseinrichtung (160) eine Optik (161) und einen Bildsensor (162) aufweist, wobei die Optik (161) dazu eingerichtet ist, das bereitgestellte Muster (P1 - P5) mit den Ortsfrequenzen von zumindest 1/(500 µm) mit einer Intensitätsabschwächung von höchstens 99 % auf den Bildsensor (162) abzubilden, und
Ermitteln der Position des Spiegels in Abhängigkeit von dem erfassten Muster.

## Claims

1. Position sensor apparatus (140) for ascertaining a position of at least one mirror (M1-M6) of a lithography apparatus (100), comprising:
a pattern provision device (150), coupled to the mirror (M4), for providing a pattern (P1-P5) which has an information content at spatial frequencies of at least 1/(500 µm),
an image recording device (160) for recording the provided pattern (P1-P5), wherein the image recording device (160) has an optical unit (161) and an image sensor (162), wherein the optical unit (161) is configured to image the provided pattern (P1-P5) with the spatial frequencies of at least 1/(500 µm) with an intensity attenuation of at most 99% onto the image sensor (162), and
an image evaluation device (170) for ascertaining the position of the mirror (M4) in dependence on the recorded pattern (P1-P5).

2. Position sensor apparatus according to Claim 1, wherein the image sensor (162) and the image evaluation device (170) are provided in the same integrated assembly (200).

3. Position sensor apparatus according to Claim 1 or 2, wherein the pattern provision device (150) is configured to provide the pattern (P4, P5) with a first pattern portion for a coarse determination of the position of the mirror (M4) and with a second pattern portion for a fine determination of the position of the mirror (M4), with the second pattern portion having an information content at spatial frequencies of at least 1/(500 µm).

4. Position sensor apparatus according to any of Claims 1 to 3, wherein the pattern provision device (150) is configured to provide the pattern (P1-P5) with a periodic pattern which has an information content at spatial frequencies of at least 1/(500 µm).

5. Position sensor apparatus according to Claim 1 or 2, wherein the pattern provision device (150) is configured to provide the pattern (P4, P5) with a line (L) with a predetermined gradient (Θ) for a coarse determination of the position of the mirror (M4) and with a periodic pattern (P6) for a fine determination of the position of the mirror (M4), which pattern has an information content at spatial frequencies of at least 1/(500 µm).

6. Position sensor apparatus according to Claim 5, wherein the pattern provision device (150) is configured to provide the pattern (P4) with a first pattern portion (A1) in which the periodic pattern (P6) is arranged, and with a second pattern portion (A2) which is separate from the first pattern portion (A1) and in which the line (L) with the predetermined gradient (Θ) is arranged.

7. Position sensor apparatus according to Claim 5, wherein the pattern provision device (150) is configured to provide the pattern (P5) in a manner such that the line (L) with the predetermined gradient(Θ) is superposed on the periodic pattern (P6).

8. Position sensor apparatus according to any of Claims 4 to 7, wherein the periodic pattern (P1-P5) is a sine pattern (P1, P2, P4, P5), a rectangular pattern or a chirp signal pattern (P3).

9. Position sensor apparatus according to any of Claims 1 to 8, wherein the image evaluation device (170) is configured to determine the position of the mirror (M4) by means of a Fourier transform (T2), in particular by means of a discrete Fourier transform, of the recorded pattern (P2).

10. Position sensor apparatus according to Claim 9, wherein the image evaluation device (170) is configured to derive a spatial frequency of the recorded pattern (P2) from a maximum value (C) of an amplitude of the Fourier transform (T2) and to derive a displacement of the pattern (P2) relative to a reference position from a phase of the Fourier transform (T2) at the derived spatial frequency.

11. Position sensor apparatus according to Claim 9, wherein the image evaluation device (170) is configured to derive the position of the mirror exclusively from a phase of the Fourier transform (T2) in a pattern with a fixed spatial frequency.

12. Position sensor apparatus according to any of Claims 1 to 8, wherein the image evaluation device (170) is configured to determine the position of the mirror (M4) by means of a Radon transform (R).

13. Position sensor apparatus according to any of Claims 1 to 8, wherein the image evaluation device (170) is configured to determine the position of the mirror (M4) by means of a Radon transform (R) using the central slice theorem.

14. Position sensor apparatus according to any of Claims 1 to 13, wherein the pattern provision device (150), the image recording device (160) and the image evaluation device (170) are arranged in a vacuum housing (137).

15. Projection system (104) of a lithography apparatus (100), comprising:
a plurality N of mirrors (M1-M6), which comprise a number M of actuable mirrors, with M ≤ N, and
a plurality X of position sensor apparatuses (140) according to any of Claims 1 to 14.

16. Projection system according to Claim 15, wherein M ≤ X ≤ 6 · M.

17. Projection system according to Claim 15 or 16, wherein in each case six position sensor apparatuses (140) are assigned to one of the actuable mirrors, with X = 6 · M.

18. Lithography apparatus (100) having a projection system (140) according to any of Claims 15 to 17.

19. Method for ascertaining a position of at least one mirror of a lithography apparatus, comprising:
providing a pattern which is coupled to the mirror and has an information content at spatial frequencies of at least 1/(500 µm),
recording the provided pattern by means of an image recording device (160), wherein the image recording device (160) has an optical unit (161) and an image sensor (162), wherein the optical unit (161) is configured to image the provided pattern (P1-P6) with the spatial frequencies of at least 1/(500 µm) with an intensity attenuation of at most 99% onto the image sensor (162), and
ascertaining the position of the mirror in dependence on the recorded pattern.

## Revendications

1. Dispositif de détection de position (140) destiné à déterminer une position d'au moins un miroir (M1 - M6) d'une installation de lithographie (100), ledit dispositif comportant :
un module de fourniture de motif (150) couplé au miroir (M4) et destiné à fournir un motif (P1 - P5) qui présente un contenu informationnel à des fréquences spatiales d'au moins 1/(500 µm),
un module de capture d'image (160) destiné à capturer le motif fourni (P1 - P5), le module de capture d'image (160) comportant une optique (161) et un capteur d'image (162), l'optique (161) étant conçue pour reproduire le motif fourni (P1 - P5) avec les fréquences spatiales d'au moins 1/(500 µm) avec une atténuation d'intensité d'au plus 99 % sur le capteur d'image (162), et
un module d'évaluation d'image (170) destiné à déterminer la position du miroir (M4) en fonction du motif capturé (P1 - P5).

2. Dispositif de détection de position selon la revendication 1, le capteur d'image (162) et le module d'évaluation d'image (170) sont prévus dans le même ensemble intégré (200).

3. Dispositif de détection de position selon la revendication 1 ou 2, le module de fourniture de motif (150) étant conçu doter le motif (P4, P5) d'une première partie de motif destinée à une détermination grossière de la position du miroir (M4) et d'une deuxième partie de motif destinée à une détermination fine de la position du miroir (M4), la deuxième partie de motif présentant un contenu informationnel à des fréquences spatiales d'au moins 1/(500 µm).

4. Dispositif de détection de position selon l'une des revendications 1 à 3, le module de fourniture de motif (150) étant conçu pour doter le motif (P1 - P5) d'un motif périodique qui présente un contenu informationnel à des fréquences spatiales d'au moins 1/(500 µm).

5. Dispositif de détection de position selon la revendication 1 ou 2, le module de fourniture de motif (150) étant conçu pour doter le motif (P4, P5) d'une ligne (L) de pente prédéterminée (Θ) destinée à une détermination grossière de la position du miroir (M4) et d'un motif périodique (P6) destiné à une détermination fine de la position du miroir (M4) qui présente un contenu informationnel à des fréquences spatiales d'au moins 1/(500 µm).

6. Dispositif de détection de position selon la revendication 5, le module de fourniture de motif (150) étant conçu pour doter le motif (P4) d'une première partie de motif (A1) dans laquelle le motif périodique (P6) est disposé et d'une deuxième partie de motif (A2) qui est séparée de la première partie de motif (A1) et dans laquelle la ligne (L) de pente prédéterminée (Θ) est disposée.

7. Dispositif de détection de position selon la revendication 5, le module de fourniture de motif (150) étant conçu pour fournir le motif (P5) de manière à ce que la ligne (L) de pente prédéterminée (Θ) soit superposée au motif périodique (P6).

8. Dispositif de détection de position selon l'une des revendications 4 à 7, le motif périodique (P1 - P5) étant un motif sinusoïdal (P 1, P2, P4, P5), un motif rectangulaire ou un motif de signal à modulation par compression d'impulsions (P3).

9. Dispositif de détection de position selon l'une des revendications 1 à 8, le module d'évaluation d'image (170) étant conçu pour déterminer la position du miroir (M4) au moyen d'une transformation de Fourier (T2), en particulier au moyen d'une transformation de Fourier discrète, du motif capturé (P2).

10. Dispositif de détection de position selon la revendication 9, le module d'évaluation d'image (170) étant conçu pour déduire une fréquence spatiale du motif capturé (P2) à partir d'une valeur maximale (C) d'une amplitude de la transformée de Fourier (T2) et déduire un décalage du motif (P2) vers une position de référence à partir d'une phase de la transformée de Fourier (T2) à la fréquence spatiale déduite.

11. Dispositif de détection de position selon la revendication 9, le module d'évaluation d'image (170) étant conçu pour déduire la position du miroir exclusivement à partir d'une phase de la transformée de Fourier (T2) dans le cas d'un motif à fréquence spatiale fixe.

12. Dispositif de détection de position selon l'une des revendications 1 à 8, le module d'évaluation d'image (170) étant conçu pour déterminer la position du miroir (M4) au moyen d'une transformée de Radon (R).

13. Dispositif de détection de position selon l'une des revendications 1 à 8, le dispositif d'évaluation d'image (170) étant conçu pour déterminer la position du miroir (M4) au moyen d'une transformée de Radon (R) à l'aide du théorème de la coupe centrale.

14. Dispositif de détection de position selon l'une des revendications 1 à 13, le module de fourniture de motif (150), le module de capture d'image (160) et le module d'évaluation d'image (170) sont disposés dans un boîtier sous vide (137).

15. Système de projection (104) d'une installation de lithographie (100), ledit système de projection comportant :
une pluralité N de miroirs (M1 - M6) qui comprend un nombre M de miroirs actionnables , avec M ≤ N, et
une pluralité X de dispositifs de détection de position (140) selon l'une des revendications 1 à 14.

16. Système de projection selon la revendication 15, avec M ≤ X ≤ 6 · M.

17. Système de projection selon la revendication 15 ou 16, chacun des six dispositifs de détection de position (140) étant associé à l'un des miroirs actionnables, avec X = 6 · M.

18. Installation de lithographie (100), comportant un système de projection (140) selon l'une des revendications 15 à 17.

19. Procédé de détermination d'une position d'au moins un miroir d'une installation de lithographie, ledit procédé comprenant les étapes suivantes :
fournir un motif qui est couplé au miroir et qui présente un contenu informationnel à des fréquences spatiales d'au moins 1/(500 µm),
capturer le motif fourni au moyen d'un module de capture d'image (160), le module de capture d'image (160) comportant une optique (161) et un capteur d'image (162), l'optique (161) étant conçu pour reproduire le motif fourni (P1 - P5) avec les fréquences spatiales d'au moins 1/(500 µm) avec une atténuation d'intensité d'au plus 99 % sur le capteur d'image (162), et
déterminer la position du miroir en fonction du motif capturé.
